# EUROPÄISCHE PATENTANMELDUNG

(11) **EP 3 208 941 A1**
(43) Veröffentlichungstag der Anmeldung: **23.08.2017**
(21) Anmeldenummer: 16156669.0
(22) Anmeldetag: 22.02.2016
(51) Int. Cl.: H03K 17/785, H03K 17/687, G06F 11/07

(54) **SCHALTUNGSANORDNUNG FÜR EINE FEHLERSICHERE SIGNALAUSGABE UND ELEKTRISCHES GERÄT**

(71) Anmelder: Siemens Aktiengesellschaft, 80333 München (DE)
(72) Erfinder: Fachet, Benjamin, 04703 Leisnig (DE)

(57) **Zusammenfassung**

Die Erfindung betrifft eine Schaltungsanordnung (1) für eine fehlersichere Signalausgabe an einem Ausgang (A) eines Digitalbausteins (MC), mit einem Eingang (E1), welcher mit einem Primär-Schaltmittel (T1) verbunden ist, wobei das Primär-Schaltmittel (T1) ausgestaltet ist bei Anliegen einer Spannung am Eingang (E1) einen Stromfluss(I_{D1}) in einem Primär-Zweig (21) eines Potentialtrennmittels (20) auszulösen, wobei das Potentialtrennmittel (20) ausgestaltet ist durch den Stromfluss (I_{D1}) in dem Primär-Zweig (21) eine Spannungsquelle (23) in einem Sekundär-Zweig (22) des Potentialtrennmittels (20) zu bilden, wobei der Sekundär-Zweig (22) derart an ein Sekundär-Schaltmittel (T2) angeschlossen ist, dass eine Spannung (U_{Dn}) der Spannungsquelle (23) das Sekundär-Schaltmittel (T2) in einen ersten Schaltzustand (Z1) schaltet, wobei das Sekundär-Schaltmittel (T2) einen Sicherheitsanschluss (31) aufweist, welcher mit dem Ausgang (A) verbindbar ist, dabei ist das Sekundär-Schaltmittel (T2) ausgestaltet in dem ersten Schaltzustand (Z1) den Ausgang (A) von einem Bezugspotential (GND) zu entkoppeln und in einem zweiten Schaltzustand (Z2) den Ausgang (A) mit dem Bezugspotential (GND) zu verbinden, wobei das Sekundär-Schaltmittel (T2) ausgestaltet ist in den zweiten Schaltzustand (Z2) zu schalten, wenn die Spannung (U_{Dn}) der Spannungsquelle (23) einen Grenzwert unterschreitet.

## Beschreibung

Die Erfindung betrifft eine Schaltungsanordnung für eine fehlersichere Signalausgabe an einem Ausgang eines Digitalbausteins.

Des Weiteren betrifft die Erfindung ein elektrisches Gerät umfassend einen Digitalbaustein mit einem Ausgang und einer Schaltungsanordnung für eine fehlersichere Signalausgabe an dem Ausgang.

Eine hohe Fehlersicherheit ist ein entscheidendes Kriterium für eine funktionale Sicherheit einer Maschine oder eines elektrischen Gerätes oder einer industriellen Anlage. Im Falle eines Bauteilversagens führen die meisten Fehlerzustände zu einem unsicheren Zustand, bei welchen ein Signal auf einem bestimmten Wert stehen bleibt, weil beispielsweise die Signalspannung entweder mit einer Masse oder mit einer positiven Versorgungsspannung verbunden ist. Tritt ein solcher Fehler am Ausgang einer digitalen Ausgangsschaltung einer Baugruppe auf, so kann diese Baugruppe unter anderem einen kritischen Zustand einnehmen. Insbesondere in sicherheitsgerichteten Anlagen müssen Fehler aller Art erkannt und so beherrscht werden, dass sie keine unzulässigen Reaktionen auslösen.

Bei elektrischen Geräten existiert daher die Anforderung an eine hohe Verfügbarkeit und Sicherheit (Failsafe), wobei das elektrische Gerät ein definiertes Verhalten bei Versagen internen Komponenten zeigen muss.

Der Erfindung liegt die Aufgabe zugrunde, eine Schaltungsanordnung zur fehlersicheren Ausgabe eines Signals an einem Ausgang eines Digitalbausteines zu schaffen.

Diese Aufgabe wird durch eine Schaltungsanordnung mit folgenden Merkmalen gelöst. Schaltungsanordnungen für eine fehlersichere Signalausgabe an einem Ausgang eines Digitalbausteins, mit einem Eingang, welcher mit einem Primär-Schaltmittel verbunden ist, wobei das Primär-Schaltmittel ausgestaltet ist, bei Anliegen einer Spannung am Eingang einen Stromfluss in einem Primär-Zweig eines Potentialtrennmittels auszulösen, wobei das Potentialtrennmittel ausgestaltet ist, durch den Stromfluss in dem Primär-Zweig eine Spannungsquelle in einem Sekundär-Zweig des Potentialtrennmittels zu bilden, wobei der Sekundär-Zweig derart an ein Sekundär-Schaltmittel angeschlossen ist, dass eine Spannung der Spannungsquelle das Sekundär-Schaltmittel in einen ersten Schaltzustand schaltet, wobei das Sekundär-Schaltmittel einen Sicherheitsanschluss aufweist, welcher mit dem Ausgang verbindbar ist, dabei ist das Sekundär-Schaltmittel ausgestaltet, in dem ersten Schaltzustand den Ausgang von einen Bezugspotential zu Entkoppeln und in einem zweiten Schaltzustand den Ausgang mit dem Bezugspotential zu verbinden, wobei das Sekundär-Schaltmittel ausgestaltet ist, in den zweiten Schaltzustand zu schalten, wenn die Spannung der Spannungsquelle einen Grenzwert unterschreitet.

Die Schaltungsanordnung kann mit Vorteil innerhalb von elektrischen Geräten eingesetzt werden, da innerhalb des elektrischen Gerätes digitale Signale geschaltet werden müssen, wobei man für jedes Signal jeweils einen "sicheren Zustand" und einen "unsicheren Zustand" unterscheidet.

Der sichere Zustand entspricht einem Signalpegel, der bei Versagen einer Komponente immer erreicht werden muss. Der unsichere Zustand entspricht einem Signalpegel, der bei dem vorgesehenen Betrieb eines elektrischen Gerätes kontrolliert eingenommen wird, jedoch darf das Versagen eines Bauteils oder einer Komponente keinesfalls dazu führen, dass dieser Signalpegel unbeabsichtigt oder dauerhaft eingenommen wird.

In einer vorteilhaften Weiterbildung ist das Potentialtrennmittel derart ausgestaltet, das in dem Primär-Zweig eine LED und in dem Sekundär-Zweig ein Foto-Dioden-Array angeordnet ist. Die LED wandelt einen elektrischen Strom in Lichtleistung um. Das Foto-Dioden-Array, insbesondere aufgebaut als in Reihe geschaltete Photodioden, welcher als Fotovoltarkzelleen arbeiten, generieren dabei mit Hilfe der Lichtleistung der LED eine potential getrennte Spannungsquelle mit einer begrenzten Leistung.

Eine besonders vorteilhafte Ausgestaltung sieht vor, dass das Sekundär-Schaltmittel als ein Sperrschicht-Feldeffekttransistor ausgestaltet ist. Ein Sperrschicht-Feldeffekttransistor ist ohne eine Ansteuerung am Gate des Transistors leitend. Dementsprechend ist er sperrend wenn die LED leuchtet und eine Spannung in dem Foto-Dioden-Array erzeugt, welches bedeutet ein Signal liegt am Eingang der Schaltungsanordnung an und somit liegt kein Fehler vor. Wenn kein Fehler vorliegt wird der Ausgang durch den Sicherheitsanschluss nicht auf das "sichere" Potential geschaltet.

Für den Fall, dass der Sperrschicht-Feldeffekttransistor als ein n-Kanal-Typ ausgestaltet ist, ist der Sicherheitsanschluss mit dem Drain-Anschluss des der Sperrschicht-Feldeffekttransistor verbunden.

Für den Fall, dass der der Sperrschicht-Feldeffekttransistor als ein P-Kanal-Typ ausgestaltet ist, ist der Sicherheitsanschluss mit dem Source-Anschluss des der Sperrschicht-Feldeffekttransistors verbunden.

In einem Ausgangszustand, d.h. das Gate-Potential entspricht ungefähr dem Source-Drain-Potential, wird ein Stromfluss von Source nach Drain (und umgekehrt) ermöglicht. Dies wird genutzt um das zu schaltende Signal an dem Ausgang auf einen sicheren Pegel zu schalten. Mit einer Änderung des Gate-Potentials lässt sich der leitfähige Kanal zwischen Source und Drain abschnürren. Der Transistor wird damit hochohmig und gibt das zu schaltende Signal am Ausgang frei.

Die eingangs genannte Aufgabe wird ebenfalls durch ein elektrisches Gerät gelöst, umfassend einen Digitalbaustein mit einem Ausgang und einer Schaltungsanordnung für eine fehlersichere Signalausgabe an dem Ausgang, aufweisend einen Eingang, welcher mit einem Primär-Schaltmittel verbunden ist, wobei das Primär-Schaltmittel ausgestaltet ist, bei Anliegen einer Spannung am Eingang einen Stromfluss in einem Primär-Zweig eines Potentialtrennmittels auszulösen, wobei das Potentialtrennmittel ausgestaltet ist, durch den Stromfluss in dem Primär-Zweig eine Spannungsquelle in einem Sekundär-Zweig des Potentialtrennmittels zu bilden, wobei der Sekundär-Zweig derart an ein Sekundär-Schaltmittel angeschlossen ist, dass eine Spannung der Spannungsquelle das Sekundär-Schaltmittel in einen ersten Schaltzustand schaltet, wobei das Sekundär-Schaltmittel einen Sicherheitsanschluss aufweist, welcher mit dem Ausgang verbunden ist, dabei ist das Sekundär-Schaltmittel ausgestaltet in dem ersten Schaltzustand den Ausgang von einen Bezugspotential zu entkoppeln und in einen zweiten Schaltzustand den Ausgang mit den Bezugspotential zu verbinden, wobei das Sekundär-Schaltmittel ausgestaltet ist, den zweiten Schaltzustand in den zweiten Schaltzustand zu schalten, wenn die Spannung der Spannungsquelle einen Grenzwert unterschreitet. Insbesondere das Schalten in den zweiten Schaltzustand stellt das Bereitstellen eines sicheren Zustandes dar. Da im zweiten Schaltzustand der Ausgang mit den Bezugspotential verbunden ist, wird der Ausgang das gewünschte Potential, beispielsweise Ground, annehmen, wobei Ground als sicherer Zustand definiert ist.

In einer weiteren Ausgestaltung ist bei dem elektrischen Gerät an dem Eingang ein Überwachungsmittel angeschlossen, welches ausgestaltet ist, eine Funktion einer sicherheitsrelevanten Komponente zu überwachen.

Um die Funktion mehrerer sicherheitsrelevanten Komponenten zu überwachen, weist das elektrische Gerät eine weitere Schaltungsanordnung mit einem weiteren Eingang und einem weiteren Sicherheitsanschluss auf, wobei an dem weiteren Eingang ein weiteres Überwachungsmittel zur Überwachung einer weiteren sicherheitsrelevanten Komponente angeschlossen ist und der Sicherheitsanschluss und der weitere Sicherheitsanschluss zusammen an den Ausgang geschaltet sind. Dieses Zusammenschalten der beiden Sicherheitsanschlüsse bildet quasi eine logische UND-Verknüpfung und lässt den Ausgang in den sicheren Zustand gehen sobald eines der beiden Überwachungsmittel einen Fehlerfall gemeldet hat.

Insbesondere für den Einsatz in Failsave-Industrie-Automatisierungssystemen ist das elektrische Gerät ausgestaltet als ein fehlersicheres Automatisierungsgerät, wobei das Überwachungsmittel ausgestaltet ist, eine Versorgungsspannung zu überwachen und bei Verlust der Versorgungsspannung die Spannung am Eingang abzuschalten, wodurch der Ausgang mittels des Sicherheitsanschlusses in einen sicheren Zustand schaltbar ist.

Auch bei Verlust einer Versorgungsspannung des elektrischen Gerätes oder Versagen einer Stromversorgungseinrichtung oder Abschalten eines Gerätes bei Wartungsarbeiten, muss der Übergang des Signalpegels beliebiger Ausgänge in einen sicheren Zustand sichergestellt sein. Auch können in dem elektrischen Gerät einzelne der vielzähligen internen Versorgungsspannungen durch einen Defekt ausfallen, so dass logische Verknüpfungen, die aus verschiedenen Versorgungen gespeist werden, sich nach dem sicheren Zustandsprinzip verhalten.

Die Zeichnung zeigt ein Ausführungsbeispiel. Es zeigen
- FIG 1: eine Schaltungsanordnung für eine fehlersichere Signalausgabe an einem Ausgang,
- FIG 2: eine Integration der Schaltungsanordnung aus FIG 1 in ein elektrisches Gerät und
- FIG 3: Prinzip-Schaltzustände für die Einnahme eines sicheren Zustandes.

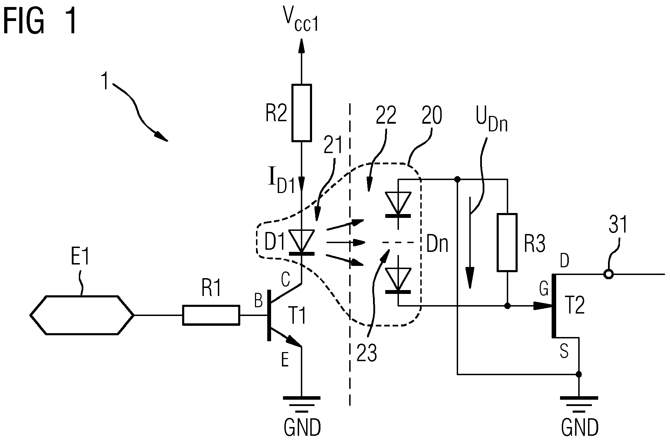

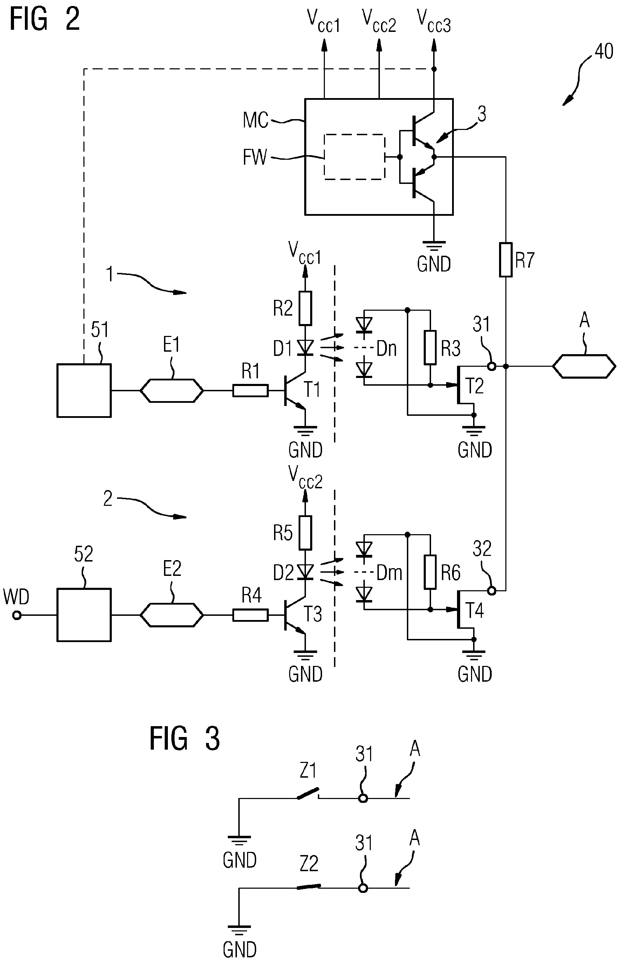

Gemäß FIG 1 ist eine Schaltungsanordnung 1 für eine fehlersichere Signalausgabe eines Ausganges A eines Digitalbausteins MC (siehe FIG 2) dargestellt. Die FIG 1 zeigt die reine Schaltungsanordnung 1 wie sie später in einem elektrischen Gerät eingesetzt wird. Der eigentliche zu sichernde Ausgang A ist in der FIG 1 noch nicht dargestellt. Die Schaltungsanordnung 1 weist einen ersten Sicherheitsanschluss 31 auf, welcher bei Einsatz in einem elektrischen Gerät mit dem zu sichernden Ausgang A verbunden wird. Der Sicherheitsanschluss 31 ist mit einem Sekundär-Schaltmittel T2 verbunden. Das Sekundär-Schaltmittel T2 ist als ein N-Kanal Sperrschicht-Feldeffekttransistor ausgestaltet. Ein Drain-Anschluss D des Sperrschicht-Feldeffekttransistors bildet den Sicherheitsanschluss 31 und kann bei Freigabe der Drain-Source-Strecke den Sicherheitsanschluss 31, welcher mit dem zu sichernden Ausgang A verbunden ist, auf das Bezugspotential GND schalten.

Um der Schaltungsanordnung 1 das Signal für ein sicheres Schalten zu geben, weist die Schaltungsanordnung 1 einen Eingang E1 auf, welcher mit einem Primär-Schaltmittel T1 verbunden ist, das Primär-Schaltmittel T1, beispielsweise ein Transistor, ist ausgestaltet bei Anliegen einer Spannung am Eingang E1 einen Stromfluss I_{D1} in einen Primär-Zweig 21 eines Potentialtrennmittels 20 auszulösen. Das Potentialtrennmnittel 20 ist dabei derart ausgestaltet, das durch den Stromfluss I_{D1} in dem Primär-Zweig 21 eine Spannungsquelle 23 in einem Sekundär-Zweig 22 des Potentialtrennmitels 20 gebildet wird.

Der Sekundär-Zweig 22 ist derart an das Sekundär-Schaltmittel T2 angeschlossen, dass eine Spannung U_{Dn} der Spannungsquelle 23 das Sekundär-Schaltmittel T2 in einen ersten Schaltzustand Z1 schaltet, wobei das Sekundär-Schaltmittel T2 den Sicherheitsanschluss 31 aufweist, welcher wiederum bei Einsatz in einem elektrischen Gerät 40 mit dem Ausgang A verbindbar ist. Das Sekundär-Schaltmittel T2 ist ausgestaltet, in dem ersten Schaltzustand Z1 den Ausgang A von einem Bezugspotential GND zu entkoppeln und in einem zweiten Schaltzustand Z2, nämlich den sicheren Zustand, den Ausgang A mit dem Bezugspotential GND zu verbinden, wobei das Sekundär-Schaltmittel T2 ausgestaltet ist, in dem zweiten Schaltzustand Z2 zu schalten, wenn die Spannung U_{Dn} von der Spannungsquelle 23 einen Grenzwert unterschreitet.

Ein mögliches Szenario wäre folgendes: Am Eingang E1 liegt ein positives Signal an, welches bedeutet, eine zu überprüfende Versorgungsspannung ist einwandfrei. Sollte dieses positive Signal am Eingang E1 aufgrund eines Fehlerfalles oder bei Versagen der Versorgungsspannung wegfallen, so schaltet das Primär-Schaltmittel T1 in einen Sperrzustand, weil es nicht mehr über den Widerstand R1 angesteuert wird. Da nun das Primär-Schaltmittel T1 sperrt, kann über die Kollektor-Emitter-Strecke des Primär-Schaltmittels T1 kein Strom mehr fließen und somit kann die LED D1 kein Licht mehr Aussenden und es fließt kein Strom I_{D1}. Wird nun aber kein Licht mehr von der LED D1 ausgesendet, wird auch in dem Foto-Dioden-Array Dn keine Spannung U_{Dn} erzeugt. Da das Foto-Dioden-Array Dn die Gate-Source-Spannung für das Sekundär-Schaltmittel T2 bereitstellt, diese aber nicht vorhanden ist, geht das Sekundär-Schaltmittel T2 in den leitenden Zustand, da ein Sperrschicht-Feldeffekttransistor ohne Ansteuerung leitend wird. Der leitende Zustand symbolisiert den zweiten Schaltzustand Z2 (siehe FIG 3) und somit zieht der erste Sicherheitsanschluss 31 über das Sekundär-Schaltmittel T2 den zu sichernden Ausgang A auf ein sicheres Bezugspotential GND.

Mit der FIG 2 ist ein elektrisches Gerät 40 mit einem Digitalbaustein MC dargestellt. Der Digitalbaustein MC weist den Ausgang A auf, für welchen gilt diesen in einem Fehlerfall in einen sicheren Zustand zu bringen. Der Digitalbaustein MC, beispielsweise ein Mikroprozessor, wird durch eine Firmware FW gesteuert und weist ein Ausgangsschaltmittel 3 auf, welches ebenfalls durch die Firmware FW gesteuert wird. Um den Ausgang A des Digitalbausteins MC fehlersicher zu machen, sind in dem elektrischen Gerät 40 eine erste Schaltungsanordnung 1 und eine weitere Schaltungsanordnung 2 angeordnet, beide sind aufgebaut wie es detailliert gemäß FIG 1 beschrieben wurde. Die erste Schaltungsanordnung 1 weist den ersten Sicherheitsanschluss 31 auf und die zweite Schaltungsanordnung 2 weist einen zweiten Sicherheitsanschluss 32 auf. Beide Sicherheitsanschlüsse 31,32 sind mit dem Ausgang A verbunden. Der erste Eingang E1 der Schaltungsanordnung 1 ist mit einem ersten Überwachungsmittel 51 verbunden, welches ausgestaltet ist, eine dritte Versorgungsspannung V_{CC3} zu überwachen. Eine erste Versorgungsspannung V_{CC1} wird für den Betrieb der ersten Schaltungsanordnung 1 eingesetzt und eine zweite Versorgungsspannung V_{CC2} wird für den Betrieb der weiteren Schaltungsanordnung 2 eingesetzt. Die weitere Schaltungsanordnung 2 weist einen zweiten Eingang E2 auf, welcher mit einem zweiten Überwachungsmittel 52 verbunden ist. Das zweite Überwachungsmittel 52 ist ausgestaltet, die auf dem Digitalbaustein MC arbeitende Firmware FW mit einen Watsch-Dog WD zu überwachen. Bei Ausfall der Firmware FW und somit ausbleibender Signalisierung zum Überwachungsmittel 52 schaltet dieses am zweiten Eingang E2 kein Signal mehr an und die weitere Schaltungsanordnung 2, ausgestaltet mit einem weiteren Primär-Schaltmittel T3 und einem weiteren Sekundär-Schaltmittel T4, sowie einem weiteren Potentialtrennmittel mit einer weiteren LED D2 und einem weiteren Foto-Dioden-Array Dm, sorgt dafür, dass das weitere Sekundär-Schaltmittel T4 ebenfalls ausgestaltet als ein Sperrschicht-Feldeffekttransistor, den zweiten Sicherheitsanschluss 32 ebenfalls auf das Bezugspotential GND schaltet und damit den Ausgang A in einen sicheren Zustand bringt. Egal welches Überwachungsmittel 51,52 jetzt einen Fehler meldet, in jedem Fall wird der Ausgang A auf ein sicheres Bezugspotential GND gebracht und damit in einen sicheren Zustand gebracht.

FIG 3 stellt symbolisch den ersten Schaltzustand Z1 und den zweiten Schaltzustand Z2 dar. Wobei der zweite Schaltzustand Z2 dem sicheren Zustand entspricht. Im ersten Schaltzustand Z1 ist der erste Sicherheitsanschluss 31 von dem sicheren Bezugspotential GND entkoppelt und damit kann der Ausgang A die Signalpegel annehmen wie sie von dem Digitalbaustein MC vorgegeben werden. Im zweiten Schaltzustand Z2 ist der erste Sicherheitsanschluss 31 mit dem sicheren Bezugspotential GND verbunden und damit wird der Ausgang A in den sicheren Zustand überführt.

Zusammenfassend kann gesagt werden, die Schaltungsanordnung 1 weist folgende Bauteile auf: Eine LED D1, welche die elektrische Leistung aus einer Versorgungsspannung V_{CC1} in Lichtleistung umwandelt und einen Transistor T1 dessen Funktion das Schalten des Stromflusses I_{D1} durch die LED D1 ist. Den Widerstand R1 dessen Funktion das Begrenzen des Basisstroms von T1 ist und einen Widerstand R2 dessen Funktion das Begrenzen des Stromes durch den Transistor T1 ist. Das Foto-Dioden-Array Dn besteht aus in Reihe geschalteten Foto-Dioden, welcher als Foto-Voltark-Zellen arbeiten um eine potential getrennte Spannungsquelle 23 mit begrenzter Leistung zu bilden. Der Sperrschicht-Feldeffekttransistor (JFET) der das Schalten des Ausgangssignals realisiert und einen Widerstand R3 der das Entladen des JFET-Gates beschleunigt. Vorteilhafterweise ist das Potentialtrennmittel 20 mit der LED D1 und dem Foto-Dioden-Array Dn in einem Gehäuse angeordnet. Das Gehäuse sorgt dafür, dass das Umgebungslicht abgeschottet wird und dass das Bestrahlen von dem Foto-Dioden-Array Dn durch die LED D1 ermöglicht wird. Zusätzlich ist eine galvanische Trennung des Stromkreises durch die LED D1 und des Stromkreises durch das Foto-Dioden-Array Dn gewährleistet.

Die nachfolgende Tabelle beschreibt das Verhalten der Schaltung bei technischem Versagen einzelner Komponenten der Schaltung und zeigt auf, das die Schaltungsanordnung für jeden Fehlerfall Sicherheit bietet.

| **Defekt** | **Verhalten der Schaltung** |
|---|---|
| R1 → 0 Ohm | Zerstörung von T1 → Stromfluss durch D1 unabhängig von Input-Spannung = Funktionsverlust, Output hochohmig |
| R1 → hochohmig | T1 Kollektor-Emitter Strecke wird hochohmig → Output geht in sicheren Zustand |
| Kurzschluss T1 Basis mit T1 Emitter | kein Stromfluss durch D1 → Output geht in sicheren Zustand |
| Kurzschluss T1 Basis mit T1 Kollektor | Stromfluss über Basis-Emitter-Diode von T1 (unabhängig von Input-Spannung) = Funktionsverlust, Output hochohmig |
| Kurzschluss T1 Emitter mit T1 Kollektor | Stromfluss durch D1 unabhängig von Input-Spannung = Funktionsverlust, Output hochohmig |
| Defekte Verbindung Leiterplatte-Bauteil/IC: T1 Basis | kein Stromfluss durch D1 → Output geht in sicheren Zustand |
| Defekte Verbindung Leiterplatte-Bauteil/IC: T1 Emitter | kein Stromfluss durch D1 → Output geht in sicheren Zustand |
| Defekte Verbindung Leiterplatte-Bauteil/IC: T1 Kollektor | kein Stromfluss durch D1 → Output geht in sicheren Zustand |
| Flussspannung von D1 reduziert sich | Strom durch D1 erhöht sich → höhere Lichtleistung auf Sekundär-Seite → Gatespannung und Gatestrom wird durch Dn begrenzt, kein Einfluss auf Funktion der Schaltung |
| Kurzschluss von D1 Anode und D1 Kathode | Lichtleistung zur Sekundär-Seite = 0 → Output geht in sicheren Zustand |
| Defekte Verbindung Leiterplatte-Bauteil/IC: D1 Anode | kein Stromfluss durch D1 → Output geht in sicheren Zustand |
| Defekte Verbindung Leiterplatte-Bauteil/IC: D1 Kathode | kein Stromfluss durch D1 → Output geht in sicheren Zustand |
| R2 → 0 Ohm | erhöhter Stromfluss durch D1 → Zerstörung von D1 → Lichtleistung zur Sekundär-Seite = 0 → Output geht in sicheren Zustand |
| R2 → hochohmig | Lichtleistung zur Sekundär-Seite = 0 → Output geht in sicheren Zustand |
| Vcc1 steigt aufgrund eines Defekts auf zu hohe Werte | evtl. Zerstörung von D1 durch zu hohen Strom → Output geht in sicheren Zustand |
| Kurzschluss von Anode und Kathode einer Diode Dn | geringere erzeugte Spannung des Photovoltaik-Arrays → je nach Bauelemente Auswahl kein Einfluss auf Funktion der Schaltung oder Output geht in sicheren Zustand |
| Kurzschluss des gesamtes Photovoltaik-Arrays | Output geht in sicheren Zustand |
| Defekte Verbindung Leiterplatte-Bauteil/IC: Dn 1. Anode | Gate von T2 wird durch R3 auf GND gezogen → Output geht in sicheren Zustand |
| Defekte Verbindung Leiterplatte-Bauteil/IC: Dn letzte Kathode | Gate von T2 wird durch R3 auf GND gezogen → Output geht in sicheren Zustand |
| Beschädigung der lichtundurchlässigen Umhüllung von D1 und Dn | Fremdlichtleistung kann Dn erreichen und eine Ausgangsspannung erzeugen → maximale Spannung ist durch die Flussspannung der Dioden begrenzt, erhöhter Stromfluss durch Dn wäre möglich aber Stromfluss in Gate von T2 ist durch das Funktionsprinzip begrenzt → weder T2 noch R3 werden als Folge negativ Beeinflusst → Worst-Case-Folge: Funktionsverlust, Output hochohmig |
| R3 → 0 Ohm | Gate = GND → Output geht in sicheren Zustand |
| R3 → hochohmig | der Wechsel von Input "high" auf "low" führt zu eine Stark verzögerten Reaktion von T2 da die Basisspannung nicht von R3 entladen wird → Funktionsverlust (verzögerte Reaktion) |
| Kurzschluss T2 Gate zu T2 Drain | negativer Stromfluss von Output nach Dn-Kathode → Output wird mit einem sehr kleinen Strom in Richtung des sicheren Pegels gezogen → Worst-Case Funktionsverlust / Best-Case Output geht in sicheren Zustand |
| Kurzschluss T2 Gate zu T2 Source | Gate-Potential = GND → T2 niederohmig → Output geht in sicheren Zustand |
| Kurzschluss T2 Drain zu T2 Source | Output geht in sicheren Zustand |
| Defekte Verbindung Leiterplatte-Bauteil/IC: T2 Gate | Gateladung entlädt sich langsam → Output geht in sicheren Zustand |
| Defekte Verbindung Leiterplatte-Bauteil/IC: T2 Drain | kein Stromfluss möglich → Funktionsverlust, Output hochohmig |
| Defekte Verbindung Leiterplatte-Bauteil/IC: T2 Source | - kein Stromfluss nach GND möglich → Funktionsverlust - je nach Zustand von Input und Output kann eine höhere Spannung von T2-Gate nach T2-Source entstehen, welche jedoch keinen weiteren Einfluss auf das Verhalten der Schaltung hat. |

## Patentansprüche

1. Schaltungsanordnung (1) für eine fehlersichere Signalausgabe an einem Ausgang (A) eines Digitalbausteins (MC),
mit einem Eingang (E1), welcher mit einem Primär-Schaltmittel (T1) verbunden ist, wobei das Primär-Schaltmittel (T1) ausgestaltet ist bei Anliegen einer Spannung am Eingang (E1) einen Stromfluss(I_{D1}) in einem Primär-Zweig (21) eines Potentialtrennmittels (20) auszulösen, wobei das Potentialtrennmittel (20) ausgestaltet ist durch den Stromfluss (I_{D1}) in dem Primär-Zweig (21) eine Spannungsquelle (23) in einem Sekundär-Zweig (22) des Potentialtrennmittels (20) zu bilden, wobei der Sekundär-Zweig (22) derart an ein Sekundär-Schaltmittel (T2) angeschlossen ist, dass eine Spannung (U_{Dn}) der Spannungsquelle (23) das Sekundär-Schaltmittel (T2) in einen ersten Schaltzustand (Z1) schaltet, wobei das Sekundär-Schaltmittel (T2) einen Sicherheitsanschluss (31) aufweist, welcher mit dem Ausgang (A) verbindbar ist, dabei ist das Sekundär-Schaltmittel (T2) ausgestaltet in dem ersten Schaltzustand (Z1) den Ausgang (A) von einem Bezugspotential (GND) zu entkoppeln und in einem zweiten Schaltzustand (Z2) den Ausgang (A) mit dem Bezugspotential (GND) zu verbinden, wobei das Sekundär-Schaltmittel (T2) ausgestaltet ist in den zweiten Schaltzustand (Z2) zu schalten, wenn die Spannung (U_{Dn}) der Spannungsquelle (23) einen Grenzwert unterschreitet.

2. Schaltungsanordnung (1) nach Anspruch 1, wobei das Potentialtrennmittel (20) derart ausgestaltet ist, das in dem Primär-Zweig (21) eine LED (D1) und in dem Sekundär-Zweig (22) ein Foto-Dioden-Array (Dn) angeordnet ist.

3. Schaltungsanordnung (1) nach Anspruch 1 oder 2, wobei das Sekundär-Schaltmittel (T2) als ein Sperrschicht-Feldeffekttransistor ausgestaltet ist.

4. Schaltungsanordnung (1) nach Anspruch 3, wobei für den Fall, dass der Sperrschicht-Feldeffekttransistor als ein n-Kanal-Typ ausgestaltet ist, der Sicherheitsanschluss (31) mit dem Drain-Anschluss des Sperrschicht-Feldeffekttransistors verbunden ist.

5. Schaltungsanordnung (1) nach Anspruch 3, wobei für den Fall, dass der Sperrschicht-Feldeffekttransistor als ein p-Kanal-Typ ausgestaltet ist, der Sicherheitsanschluss (31) mit dem Source-Anschluss des Sperrschicht-Feldeffekttransistors verbunden ist.

6. Elektrisches Gerät (40) umfassend
einen Digitalbaustein (MC) mit einem Ausgang (A) und
einer Schaltungsanordnung (1) für eine fehlersichere Signalausgabe an dem Ausgang (A) aufweisend
einen Eingang (E1,E2), welcher mit einem Primär-Schaltmittel (T1) verbunden ist, wobei das Primär-Schaltmittel (T1) ausgestaltet ist bei Anliegen einer Spannung am Eingang (E1) einen Stromfluss(I_{D1}) in einem Primär-Zweig (21) eines Potentialtrennmittels (20) auszulösen, wobei das Potentialtrennmittel (20) ausgestaltet ist durch den Stromfluss (I_{D1}) in dem Primär-Zweig (21) eine Spannungsquelle (23) in einem Sekundär-Zweig (22) des Potentialtrennmittels (20) zu bilden, wobei der Sekundär-Zweig (22) derart an ein Sekundär-Schaltmittel (T2) angeschlossen ist, dass eine Spannung (U_{Dn}) der Spannungsquelle (23) das Sekundär-Schaltmittel (T2) in einen ersten Schaltzustand (Z1) schaltet, wobei das Sekundär-Schaltmittel (T2) einen Sicherheitsanschluss (31) aufweist, welcher mit dem Ausgang (A) verbunden ist, dabei ist das Sekundär-Schaltmittel (T2) ausgestaltet in dem ersten Schaltzustand (Z1) den Ausgang (A) von einem Bezugspotential (GND) zu entkoppeln und in einem zweiten Schaltzustand (Z2) den Ausgang (A) mit dem Bezugspotential (GND) zu verbinden, wobei das Sekundär-Schaltmittel (T2) ausgestaltet ist in den zweiten Schaltzustand (Z2) zu schalten, wenn die Spannung (U_{Dn}) der Spannungsquelle (23) einen Grenzwert unterschreitet.

7. Elektrisches Gerät (40) nach Anspruch 6, wobei an dem Eingang (E1) eine Überwachungsmittel (51) angeschlossen ist, welches ausgestaltet ist eine Funktion einer sicherheitsrelevanten Komponente zu überwachen.

8. Elektrisches Gerät (40) nach Anspruch 6 oder 7, aufweisend eine weitere Schaltungsanordnung (2) mit einem weiteren Eingang (E2) und einem weiteren Sicherheitsanschluss (32), wobei an den weiteren Eingang (E2) ein weiteres Überwachungsmittel (52) zur Überwachung einer weiteren sicherheitsrelevanten Komponente angeschlossen ist und der Sicherheitsanschluss (31) und der weitere Sicherheitsanschluss (32) zusammen an den Ausgang (A) geschaltet sind.

9. Elektrisches Gerät (40) nach einem der Ansprüche 6 bis 8, ausgestaltet als ein fehlersicheres Automatisierungsgerät, wobei das Überwachungsmittel (51) ausgestaltet ist eine Versorgungsspannung (V_{CC3}) zu überwachen und bei Verlust der Versorgungsspannung (V_{CC3}) die Spannung am Eingang (E1) abzuschalten, wodurch der Ausgang (A) mittels des Sicherheitsanschlusses (31) in einen sichere Zustand schaltbar ist.
